# DEMANDE DE BREVET EUROPEEN

(11) **EP 1 936 008 A1**
(43) Date de publication de la demande: **25.06.2008**
(21) Numéro de dépôt: 06026746.5
(22) Date de dépôt: 22.12.2006
(51) Int. Cl.: C23C 28/00, C23C 14/35, C23C 14/56

(54) **Formation de couches par magnétron**

(71) Demandeur: AGC Flat Glass Europe SA, 1170 Bruxelles (BE)
(72) Inventeur: La désignation de l'inventeur n'a pas encore été déposée
(74) Mandataire: Decamps, Alain René François

(57) **Abrégé**

La présente invention concerne un vitrage comportant un ensemble de couches minces dont au moins une couche métallique conductrice et des couches diélectriques dans lequel au moins une couche diélectrique située sous une couche métallique est déposée par une technique de pulvérisation avec magnétron fonctionnant par impulsions à puissance élevée (HPPMS).

## Description

La présente invention concerne les techniques de dépôt de couches minces par pulvérisation sous vide de type assisté par magnérton et désignée communément sous le terme de "magnetron sputtering".

Les techniques de dépôt sous vide et notamment celles assistées par magnétron sont tributaires de multiples facteurs, notamment la nature des matériaux, les conditions de température du substrat sur lequel le dépôt est effectué, la nature des cathodes utilisées, vitesse de dépôt, la configuration de l'enceinte dans laquelle s'effectue le dépôt etc. La présence de tous ces paramètres fait que les propriétés des couches minces déposées peuvent présenter des grandeurs présentant de grandes variations pour une même nature de couche. C'est le cas notamment de la structure des couches. Le même produit peut ainsi se présenter sous forme amorphe ou cristalline, ou sous différentes structures cristallines ou mélange de structures.

L'analyse des couches déposées par ces techniques montre notamment de façon très générale des différences de propriétés avec les matériaux idéaux. Ces différences ont pour conséquence des propriétés qui s'écartent souvent de celles qui devraient être présentes et qui sont recherchées.

Un exemple de différence constatée se trouve dans les systèmes de couches appliquées sur des vitrages et comprenant des couches métalliques, notamment d'argent, et des couches diélectriques. Ces systèmes sont utilisés notamment pour leurs propriétés de réflexion sélective des rayons infrarouges et conduisent à des vitrages dits "à faible émissivité". La réflexion des rayons infrarouges est liée à la conductivité, laquelle est intimement dépendante de la structure de la couche conductrice et en particulier de son caractère lacunaire ou non, mais aussi de la configuration de l'interface avec les couches voisines et particulièrement avec les couches sous-jacentes sur lesquelles elle repose.

En raison des très faibles épaisseurs de la couche conductrice, de l'ordre habituellement d'une dizaine de nanomètres, les irrégularités de la surface de contact avec la couche support influent sensiblement sur la configuration de la couche conductrice elle-même, et par suite sur ses propriétés. Pour cette raison il est reconnu qu'il est souhaitable de disposer la couche conductrice sur un support présentant la meilleure régularité superficielle possible.

Si la couche immédiatement au contact de la couche conductrice peut en modifier les qualités, cette particularité peut s'étendre à des couches situées plus profondément dans l'empilage. C'est particulièrement vrai dans le cas d'une couche au contact de la couche conductrice qui présenterait une épaisseur relativement faible et qui, pour cette raison, n'absorberait pas les défauts de régularité de ces couches plus profondes.

Un but de l'invention est donc de proposer des vitrages comportant des ensembles de couches comprenant au moins une couche conductrice laquelle repose sur un support formé d'une couche, ou d'un système de couches diélectriques présentant une structure favorisant l'obtention des meilleures propriétés pour la couche conductrice qu'elle(s) supporte(nt).

L'invention se propose encore de fournir des couches présentant des interfaces plus lisses et homogènes.

Un autre but de l'invention est de fournir des couches d'argent dont la conductivité est accrue pour une même masse d'argent déposée par unité de surface. En application de ces qualités, un but de l'invention est de fournir des vitrages présentant une réflexion sélective des rayons infrarouges améliorée, et par suite une meilleure émissivité dans les vitrages dits low-e, sans accroître la quantité d'argent mise en oeuvre par unité de surface, ou à l'inverse, pour une même émissivité, permettant d'utiliser moins d'argent.

Selon l'invention, le but poursuivi est atteint avec des vitrages comportant un ensemble de couches minces dont au moins une couche métallique conductrice et des couches diélectriques, dans lequel au moins une couche diélectrique située sous une couche métallique est déposée par une technique de pulvérisation avec magnétron fonctionnant par impulsions à puissance élevée (en anglais "High Power Pulsed Magnetron Sputtering" ou "HPPMS").

Des installations utilisables pour procéder à ce type de dépôt ont été proposées précédemment par exemple dans US 6,735,099. Elles permettent de produire des trains d'impulsions avec des puissances instantanées très élevées pendant des périodes très brèves de quelques microsecondes ou dizaines de microsecondes. Des dispositifs analogues sont aussi proposés dans US 6,296,742, notamment dans le but principalement d'améliorer l'utilisation du matériau constituant les cibles. Accessoirement ces dispositifs sont proposés pour améliorer l'uniformité des couches déposées ou d'améliorer le fonctionnement des installations elles mêmes et en particulier celui des pompes à ionisation. Le même type d'installation est encore décrit dans WO 2005/010228 pour l'application spécifique au dépôt assisté par magnétron notamment dans le but de prévenir l'apparition de défaut et en particulier la formation d'arcs.

La publication W0 02/103078 décrit encore une technique pulsée combinant deux moments dans le fonctionnement conduisant au dépôt d'une couche métallique, un moment de formation des éléments arrachés à la cathode correspondant à un courant de faible intensité, et un moment de précipitation des vapeurs métalliques ionisées correspondant à un courant intense.

Les installations permettant dans des systèmes pulsés d'appliquer des puissances très élevées sur des durées très brèves, comme indiqué ci-dessus, ont été essentiellement mises en oeuvre dans le but d'éviter la formation d'arcs tout en maintenant une vitesse de dépôt suffisamment importante. En particulier, ces techniques ont été présentées pour la formation de couches de matériaux diélectriques à partir de cathodes métalliques, dans des dépôts "réactifs", évitant ainsi les limitations dues au mécanisme connu sous le nom de "disparition de la cathode", mécanisme résultant de la formation sur la cathode d'une couche isolante.

Selon l'invention, il est apparu que l'utilisation des systèmes pulsés avec des puissances instantanées très supérieures aux puissances traditionnelles mises en oeuvre dans les techniques de pulvérisation magnétron, permet d'améliorer de façon sensible les propriétés des couches et notamment celles qui sont liées directement à la structure de ces couches.

La mise en oeuvre de l'invention des techniques dites HPPMS pour la constitution de certaines couches de ces systèmes, correspond à des puissances instantanées développées au niveau de la ou des cathodes. Cette puissance est rapportée à la surface de ces cathodes. C'est grâce à cette puissance que les phénomènes qui conduisent à créer sur la cathode des espèces provenant de la réaction de la cathode peuvent être évités. C'est aussi cette puissance qui permet donc de prévenir la formation d'arcs en dépit des tensions élevées mises en oeuvre. C'est encore cette puissance qui conduit les espèces déposées à une accélération importante favorisant les dépôts réguliers et compacts.

Selon l'invention, les conditions de fonctionnement des installations de "sputtering" conduisent avantageusement à des puissances instantanées qui sont supérieures à 100W/cm² de surface de cathode exposée au bombardement. Cette puissance est de préférence supérieure à 300W/cm² et de façon particulièrement préférée supérieure à 500W/cm². En pratique la puissance est limitée par les installations d'alimentation disponibles. Mais des puissances aussi élevées que 1500W/cm², sont déjà utilisables dans certaines conditions.

Des puissances aussi élevées ne peuvent être appliquées de manière prolongée sans risquer de déclencher la formation d'arcs. Par ailLes impulsions correspondantes sont en conséquence de très courtes durées. La durée de chaque impulsion n'est pas habituellement de plus de 300µs. De préférence cette durée ne dépasse pas 100µs et le plus souvent est au plus de 30µs.

Si les impulsions sont très brèves, leur fréquence fait que le processus reste suffisamment intense. Des fréquences utiles se situent par exemple entre 1Hz et 150 kHz, et de préférence entre 50Hz et 30kHz.

Les impulsions sont nécessairement interrompues par une période pendant laquelle la cathode n'est plus soumise à la tension. La durée de l'impulsion par rapport à l'ensemble est une fraction réduite de chaque période. L'intensité instantanée du dépôt fait que la vitesse de celui-ci reste suffisamment importante et du même ordre de grandeur que celui obtenu par les techniques traditionnelles.

L'impulsion sous forme de tension appliquée à la cathode ne déclenche pas instantanément une intensité élevée. Celle-ci ne se développe que progressivement au cours de l'impulsion. Pour accélérer la montée de l'intensité correspondant aussi au transfert de matériau depuis la cathode, il est donc préférable de procéder à une impulsion présentant dès l'origine la valeur la plus élevée et maintenant cette même valeur pendant toute la durée de l'impulsion. L'impulsion est alors de préférence de forme "rectangulaire". Mais en fonction du type de générateur d'impulsion utilisé, en particulier ceux mettant en oeuvre des éléments "triac", l'impulsion bien qu'importante dès l'origine n'est pas nécessairement à sa valeur la plus élevée.

Les impulsions correspondant aux tensions appliquées à la cathode dépendent de multiples facteurs y compris les facteurs géométriques. De manière générale les tensions appliquées sont supérieures à 200v. Elles ne sont pas habituellement supérieures à 10000v et le plus souvent ne dépassent pas 2000v.

Les dispositions selon l'invention peuvent être appliquées aussi bien aux dispositifs dans lesquels les cathodes fonctionnent par paires qu'à ceux dans lesquels chaque cathode est indépendante. Dans les systèmes dans lesquels deux cathodes sont utilisées en alternance (systèmes "twin") l'avantage supplémentaire de ce système bipolaire est de mieux prévenir la formation accidentelle d'arcs.

Les dispositions de l'invention peuvent aussi être mises en oeuvre avec des cathodes planes comme avec des cathodes cylindriques. Dans ce dernier cas la puissance développée n'est pas rapportée à l'ensemble de la surface du cylindre. Une manière approchée correspondante à celle des cathodes planes est de rapporter cette puissance à une surface correspondant à la projection du cylindre sur une surface plane. Autrement dit la longueur de la cathode correspondante est celle des génératrices du cylindre, et sa largeur est égale au diamètre de ce cylindre.

L'invention peut aussi être utilisée dans les techniques dans lesquelles on utilise un couple de cathodes plates ou cylindriques dont les cibles sont de nature différente, et qui fonctionnent simultanément, techniques dites de "cosputtering", l'une d'entre elles ou les deux étant alimentée(s) en mode HPPMS.

Les techniques de dépôt indiquées précédemment pour les diélectriques entrant dans la composition des systèmes comprenant au moins une couche métallique conductrice, peuvent être mises en oeuvre pour toutes les couches diélectriques disposées entre la feuille de verre et la couche conductrice ou seulement pour certaines d'entre elles. Compte tenu de leur rôle il est particulièrement important de les appliquer pour les couches dont on sait que le dépôt conduit à des structures et/ou dont la configuration peuvent être très variables selon les conditions mises en oeuvre. Il est aussi avantageux de façon générale d'utiliser ces techniques pour toutes les couches dont l'épaisseur est telle que la qualité de surface peut être plus ou moins irrégulière fonction des particularités qui se manifestent dans la croissance de ces couches.

De nombreux matériaux diélectriques sont susceptibles d'entrer dans la composition des systèmes considérés selon l'invention. Les systèmes les plus répandus comprennent une ou plusieurs couches composée d'oxydes, de nitrures ou d'oxynitrures des éléments du groupe comprenant Sn, Zn, Ti, Zr, Al, Si, Bi, Ni, Cr, Nb et les mélanges de ceux-ci.

Les couches en question sont aussi éventuellement celles de ces mêmes éléments comprenant une quantité faible d'autres éléments introduits comme dopants.

Les cibles utilisées pour les dépôts selon l'invention peuvent être des cibles métalliques ou des cibles céramiques.

Si selon l'invention une ou plusieurs couches diélectriques sous-jacentes à la couche métallique conductrice sont déposées par HPPMS, des techniques analogues peuvent aussi avantageusement être mises en oeuvre pour d'autres couches de ces systèmes. Ceci est particulièrement avantageux lorsque le système comporte plusieurs couches conductrices séparées par des couches diélectriques. Dans ce cas pour les mêmes raisons il est avantageux que la seconde couche conductrice repose sur des couches diélectriques déposées dans les conditions décrites précédemment dans l'hypothèse de systèmes ne comportant qu'une couche conductrice.

Selon l'invention, pour vitrages bas-émissifs comportant une couche d'argent, la quantité d'argent par unité de surface est habituellement comprise entre 80 et 160mg/m². Ces quantités sont choisies d'une part pour conduire à une bonne filtration des infrarouges, et d'autre part pour laisser une transmission lumineuse élevée.

La mise en oeuvre de l'invention à des quantités d'argent de 120 à 135mg/m² permet avantageusement d'obtenir une émissivité normale qui n'est pas supérieure à 0,045 et même est inférieure à 0,040.

Exprimée en termes de résistance de surface, la mise en oeuvre de l'invention, pour des quantités d'argent de 120 à 140mg/m² conduit avantageusement à une valeur au plus égale à 3,8Ω/□.

De manière plus synthétique, le bénéfice de la mise en oeuvre de l'invention peut être exprimé par ce que l'on désigne par "efficacité de l'argent". Il s'agit du produit de la quantité d'argent exprimée en mg/m², par la résistance de surface exprimée en Ω/□.

Selon l'invention l'efficacité est avantageusement inférieure à - 200LogₙQ+1400, de préférence inférieure à - 200LogₙQ+1380 et de façon particulièrement préférée inférieure à - 200LogₙQ+ 1360. Dans cette expression Q est la quantité d'argent en mg/m².

La quantité d'argent est mesurée par fluorescence X, et la résistance de surface est mesurée par méthode de courant induit sur un appareil de type" Stratometer" de la société Nagy GmbH.

L'invention est décrite de façon détaillée dans la suite au moyen d'exemples et en faisant référence aux planches de dessins dans lesquelles :
- la figure 1 représente une coupe schématique d'un vitrage comportant un système de couches du type de ceux visés selon l'invention ;
- la figure 2 est une représentation d'un type d'impulsion appliquée pour la technique utilisée selon l'invention et des effets sur l'intensité engendrée par cette impulsion ;

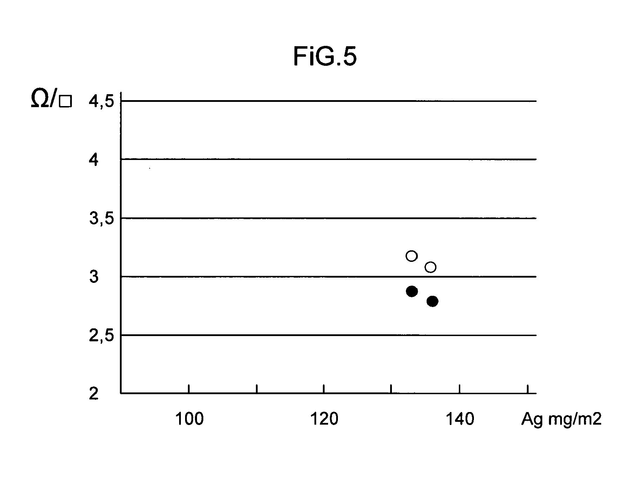

- les figures 3, 4 et 5 sont des graphiques comparant les qualités des vitrages revêtus de couches, selon l'invention et d'autres de l'art antérieur.

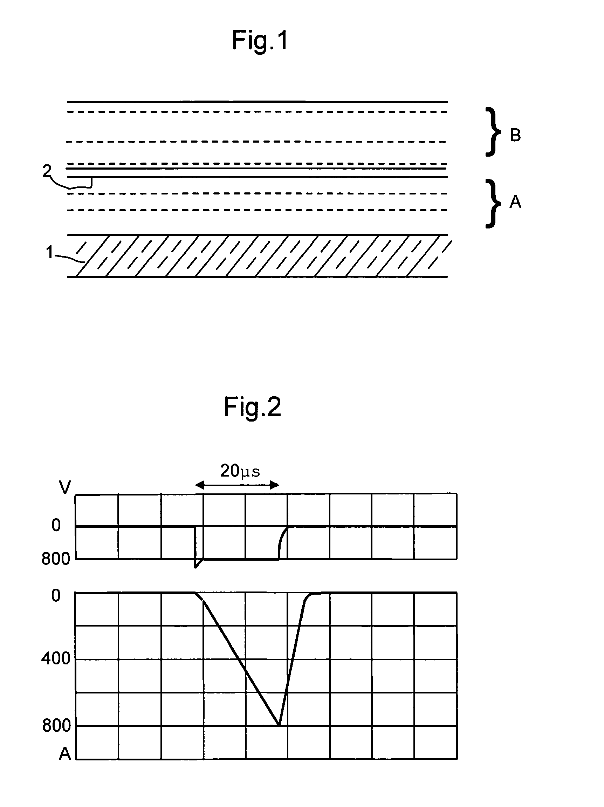

La figure 1 est en coupe la représentation des éléments constitutifs d'un vitrage comportant un système de couches selon l'invention.

Sur le substrat constitué par la feuille de verre 1 on dépose un système de couches minces par "sputtering" avec magnétron. Le système comprend nécessairement une couche métallique mince 2 réfléchissant sélectivement les infrarouges, typiquement une couche d'argent ou à base d'argent, les éléments étrangers étant par exemple du palladium, de l'aluminium, du cuivre ou du nickel. Cette couche est prise dans un ensemble de couches diélectriques désignées collectivement par A pour les couches situées entre la feuille de verre **1** et la couche métallique **2**, et par B pour les couches situées au dessus de la couche métallique.

Les couches A ont plusieurs fonctions. Il s'agit par exemple de protéger la couche métallique contre la diffusion d'ions notamment alcalins en provenance du verre. Il s'agit aussi de faire en sorte que le système de couches adhère fermement à la feuille de verre. Cet ensemble participe encore à la constitution d'un filtre sélectif en limitant la réflexion des rayons visibles et en conduisant à une coloration en réflexion aussi "neutre" que possible.

Les couches B participent de la même façon aux propriétés optiques du vitrage. Elles ont encore pour fonction de protéger la couche métallique contre les altérations chimiques qui peuvent provenir du contact avec l'atmosphère au contact du système, notamment à l'oxydation de la couche métallique. Une couche très peu épaisse (moins de 10nm en règle générale) dite "barrière" est située immédiatement au dessus de la couche métallique pour protéger celle-ci pendant les dépôts des couches supérieures, notamment lorsque celles-ci sont déposés de façon "réactive". Les couches les plus extérieures ont encore pour rôle de protéger l'ensemble contre les altérations mécaniques ou chimiques.

Dans les vitrages selon l'invention au moins une couche de l'ensemble A est déposée par une technique HPPMS. Compte tenu de l'incidence qu'elle doit avoir sur la configuration de la couche métallique cette couche peut se situer bien évidemment au contact direct de la couche métallique. On comprend que l'absence de "rugosité" à l'interface permette d'optimiser la conduction de la couche métallique pour une quantité de métal par unité de surface donnée, ou si l'on veut, pour une épaisseur donnée.

Il est apparu que la structure de la couche métallique et en particulier la qualité de sa surface peut dépendre également des couches plus profondes. De manière imagée, il est possible de concevoir que des irrégularités dans la structure des couches sous-jacentes se répercutent sur les couches directement au contact de la couche métallique, et ce d'autant plus que la couche au contact du métal est plus mince. Pour cette raison la constitution de l'une des couches ou de plusieurs de celles-ci du groupe A par la technique HPPMS, fait partie des caractéristiques des vitrages selon l'invention.

Le cas échéant une ou plusieurs couches du groupe B, peu(ven)t également être produite(s) par une technique HPPMS. Néanmoins l'incidence sur la qualité de la couche métallique est moins immédiate que celle mise en évidence pour ce qui concerne les couches de l'ensemble A.

Le système de couches représenté à la figure 1 ne comporte qu'une couche métallique. Une grande majorité des vitrages bas émissifs comportent une structure de ce type. Ils offrent des qualités d'isolation satisfaisante à un coût acceptable en conservant par ailleurs une transmission lumineuse élevée tant que l'épaisseur de la couche métallique reste relativement faible. Pour accroître encore le caractère isolant, on utilise de façon traditionnelle des empilages de couches comprenant plusieurs couches métalliques, 2 et parfois 3, séparées par des couches diélectriques. L'invention s'applique égalent à de tels vitrages. Dans ce cas l'une quelconque des couches diélectriques sous-jacente à l'une quelconque des couches métalliques, ou plusieurs de ces mêmes couches sont obtenues par HPPMS.

La figure 2 représente de manière simplifiée un type d'impulsion appliqué selon l'invention dans le cadre du dépôt d'une ou plusieurs couches diélectriques selon des modalités HPPMS.

Dans la partie supérieure du graphique l'impulsion appliquée à la cathode, mesurée en volt, est représentée en fonction du temps. L'échelle des temps est de 10µs par graduation. La ligne est lissée éliminant ainsi les oscillations minimes observées par rapport à la ligne de base, pour en simplifier la lecture.

Partant d'une tension appliquée nulle, la cathode est brusquement portée à un potentiel de 800v. Cette tension importante est maintenue dans l'exemple pendant 20µs et ramenée à 0 aussi brutalement qu'elle avait été appliquée. L'impulsion brève mais très intense est suivie d'un temps "off" relativement long pendant lequel aucune tension n'est appliquée.

L'intensité mesurée, déclenchée par l'impulsion indiquée ci-dessus, croît rapidement pour atteindre des valeurs élevées, conduisant à une puissance développée instantanée par unité de surface de cathode caractéristique des techniques HPPMS. Dans le cas représenté le pic d'intensité est atteint au moment de la fin de l'impulsion. Il se situe à environ 800A.

La fin de l'impulsion conduit à une rapide décroissance de l'intensité. Le retour à l'absence d'intensité n'est pas immédiat. Les espèces ionisées au cours du processus continuent de se déposer jusqu'à leur disparition.

La fréquence des impulsions, par exemple quelques kHz ou moins, conduit à des intervalles de temps entre deux impulsions, qui peuvent être plusieurs centaines de fois, ou même milliers de fois, la durée des impulsions. Ces mécanismes sont caractéristiques des techniques HPPMS.

Ces différences avec les techniques traditionnelles dans les conditions imposées au dispositif de dépôt, conduisent à des mécanismes spécifiques qui n'ont pas tous été complètement analysés, mais qui ont des effets certains sur les propriétés des couches comme sur le comportement des cibles et le pilotage du processus.

Pour ce qui concerne directement les caractéristiques des couches, il semble que les particularités observées proviennent notamment de l'énergie communiquée aux particules. Celle-ci apparaît sensiblement plus élevée, ce qui peut expliquer, en partie au moins, les changements de structure, notamment en évitant la croissance de structures colonnaires défavorables à l'obtention de surfaces bien "lisses".

Cette interprétation n'est donnée qu'à titre indicatif. Comme souligné, les mécanismes mis en jeu sont encore pour beaucoup l'objet d'investigations. Ils ont pour seul avantage de rendre compte des différences qui distinguent les techniques HPPMS des techniques traditionnelles comme le montrent les exemples suivants de mise en oeuvre.

Les essais sont effectués au moyen d'un module pulseur de type "SPIK 2000A-20" produit par la société MELEC.

### Exemple 1.

Dans cet exemple sur une feuille de verre "float" clair de 4mm d'épaisseur on dépose un système de couche comprenant à partir du verre :
- une couche de ZnO de 235-270Å ;
- une couche Ag à raison de 119-270mg/m2 ;
- une couche "barrière" de Ti de 30Å ;
- une couche de ZnO de 235-270Å.

On procède au dépôt des couches en courant DC "pulsed" (PMS), pour toutes les couches en dehors de celle de ZnO pour les essais selon l'invention. Dans les exemples selon l'invention, la couche de ZnO au contact du verre sous la couche d'argent, est déposée par HPPMS.

Les dépôts des couches ZnO sont de type réactif en atmosphère d'argon contenant de l'oxygène, à pression de 7mTorr.

Dans le mode traditionnel la fréquence des impulsions est de 150kHz. Compte tenu de la durée des impulsions, la puissance instantanée atteint une valeur de 2,7W/cm² de cathode. La formation de la même couche ZnO par HPPMS est effectuée à une fréquence de 3kHZ, avec des impulsions de 10µs chacune. Le pic de puissance appliquée à la cathode s'élève alors à environ 355W/cm². Cette puissance instantanée est plus de 100 fois celle mise en oeuvre selon la technique traditionnelle.

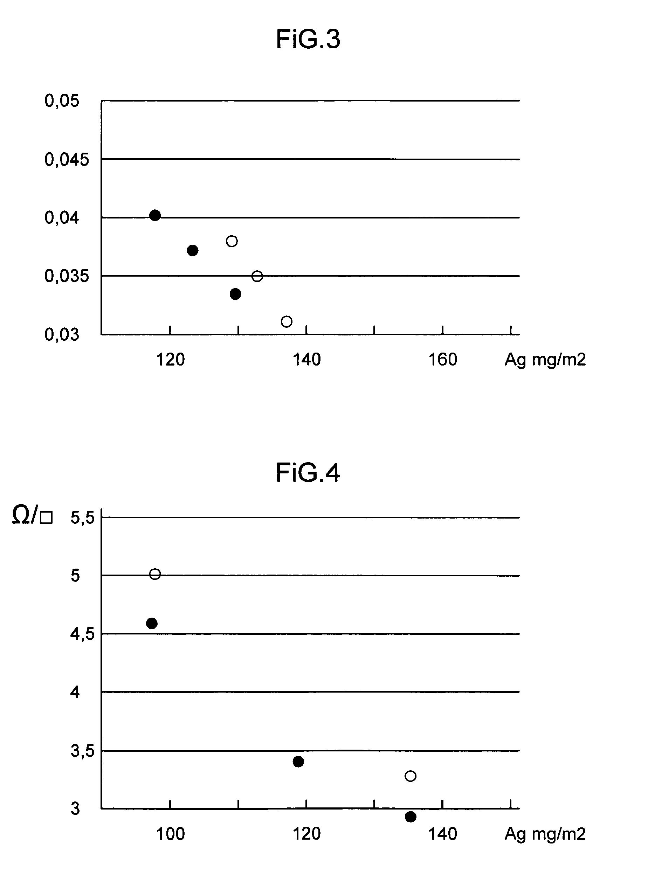

La figure 3 rapporte les valeurs d'émissivité normale du vitrage comportant ce système de couches obtenues en fonction de la quantité d'argent de la couche conductrice. Sur la figure, les points clairs correspondent aux échantillons pour lesquels les dépôts de ZnO sont réalisés suivant la technique traditionnelle, les points noirs ceux du dépôt de la première couche de ZnO par HPPMS.

On constate systématiquement que pour des quantités égales d'argent, l'émissivité normale est plus faible dans les essais selon l'invention, ou, ce qui est équivalent que l'on obtient une émissivité normale donnée en ayant une couche d'argent moins importante.

La tendance observée est encore que l'amélioration est d'autant plus sensible que la couche d'argent est moins épaisse. Ceci confirme l'hypothèse selon laquelle l'amélioration est due, au moins en partie, à une interface ZnO/Ag plus régulière. On sait en effet la tendance du ZnO, particulièrement en couche relativement épaisse à constituer des structures colonnaires. La conséquence en est, que sur une telle structure une couche mince d'argent "subit" les irrégularités d'une telle structure. Plus la couche d'argent est épaisse, moins, relativement, l'influence de ces irrégularités se fait sentir. L'avantage du vitrage selon l'invention dans le cas de couches d'argent plus épaisses tend donc à s'atténuer.

La conséquence de ces résultats est qu'il est possible de réduire la quantité d'argent dans un système donné ce qui permet le cas échéant une amélioration de la transmission lumineuse ou/et une meilleure maîtrise de la neutralité de couleur. Il est aussi possible d'atteindre simplement une meilleure émissivité.

### Exemple 2.

Dans une deuxième série d'essais, le système de couches est composé sous l'argent de deux couches distinctes. Toujours au contact de la couche d'argent se situe une couche de ZnOx de 65Å. Une couche de TiOx de 150Å est déposée de manière réactive sur le verre. Les dépôts de ZnOx et TiOx sont effectués à partir de cathodes métalliques.

Les conditions d'atmosphères sont analogues à celles de l'exemple 1.

La technique HPPMS est conduite avec une fréquence de 0,58kHz et avec des impulsions appliquées pendant 20µs selon le schéma représenté à la figure 2.

Dans un premier temps, seule la couche ZnOx est déposée en HPPMS. La puissance instantanée maximum atteint la valeur de 1115W/cm² de cathode exposée.

A titre de comparaison la couche ZnOx est cette fois déposée en courant continu non pulsé. La puissance rapportée à la surface de la cathode est de 3,6W/cm², soit approximativement 400 fois moindre qu'en HPPMS.

Les résultats sont montrés à la figure 4 dans laquelle la résistance électrique du système est mesurée en fonction de la quantité d'argent par unité de surface de la couche.

Les résistances et l'expression de l'efficacité d l'argent calculée comme indiqué précédemment sont pour les essais comparatifs et ceux selon l'invention respectivement :

| Quantité Ag mg/m² | | 100 | 120 | 135 |
|---|---|---|---|---|
| comparatif | RΩ/□ | 5 | | 3,25 |
| | efficacité | 499 | | 439 |
| selon l'invention | RΩ/□ | 4,58 | 3,45 | 2,97 |
| | efficacité | 458 | 414 | 401 |

Comme précédemment les points clairs sont ceux correspondant aux exemples comparatifs tandis que les points noirs sont ceux correspondant à l'invention.

On constate que la résistance est sensiblement moindre à quantité d'argent égale dans le cas des systèmes dans lesquels la couche ZnOx est déposée par HPPMS. On constate aussi que la différence est d'autant plus significative que la couche d'argent est moins importante.

Que la couche ZnOx soit seule sous l'argent, comme à l'exemple 1, ou qu'elle repose sur une première couche diélectrique, l'effet de l'invention est de même nature, et s'explique par les mêmes raisons.

### Exemple 3.

Cet exemple reproduit l'exemple 2, à la différence cette fois que la couche ZnOx est obtenue par dépôt DC traditionnel tandis que la couche TiOx est produite soit par DC soit en HPPMS. Autrement dit c'est la couche qui n'est pas au contact de l'argent qui fait l'objet de la comparaison.

Dans les essais la pression de l'atmosphère argon/oxygène pour le dépôt de l'oxyde de titane est à 5mTorr. La densité de puissance est de 8W/cm² en mode DC, et de 880W/cm² en mode HPPMS.

Les résultats comme à l'exemple 2 sont exprimés par la résistance en fonction de la quantité d'argent.

| Quantité Ag mg/m² | | 134 | 139 |
|---|---|---|---|
| comparatif | RΩ/□ | 3,2 | 3,1 |
| | efficacité | 429 | 431 |
| selon l'invention | RΩ/□ | 2,9 | 2,8 |
| | efficacité | 389 | 389 |

On constate encore que les produits obtenus selon l'invention présentent une résistance plus faible à quantité d'argent égale. Autrement dit l'influence sur la structure de la couche d'argent peut provenir non seulement de la couche immédiatement à son contact, mais également de façon indirecte. Comme indiqué précédemment cette incidence semble être le résultat de ce qu'une structure irrégulière sous-jacente peut conduire à une structure irrégulière de la couche qui lui est superposée et qui est en contact avec la couche conductrice, aboutissant à une altération des propriétés de cette dernière.

Bien évidemment la mise en oeuvre du dépôt HPPMS des deux couches situées sous la couche d'argent aboutit également à une meilleure conductivité de cette couche d'argent.

## Revendications

1. Vitrage comportant un ensemble de couches minces dont au moins une couche métallique conductrice et des couches diélectriques dans lequel au moins une couche diélectrique située sous une couche métallique est déposée par une technique de pulvérisation avec magnétron fonctionnant par impulsions à puissance élevée (HPPMS).

2. Vitrage selon la revendication 1 dans lequel la ou les couches métalliques sont des couches à base d'argent.

3. Vitrage selon l'une des revendications précédentes dans lequel pour les couches déposées en HPPMS, la densité de puissance par unité de surface de cathode est d'au moins 100W/cm², et de préférence d'au moins 300W/cm².

4. Vitrage selon l'une des revendications précédentes dans lequel les dépôts des couches en HPPMS sont effectués à une fréquence de 1 Hz à 150kHz et de préférence de 50Hz à 30kHz.

5. Vitrage selon la revendication 4 dans lequel chaque impulsion présente une durée qui est au plus égale à 300µs, et de préférence au plus égale à 100µs.

6. Vitrage selon la revendication5 dans lequel chaque impulsion présente une durée qui n'est pas supérieure à 30µS.

7. Vitrage selon l'une des revendications précédentes dans lequel la tension maximum d'impulsion appliquée est au plus égale à 10000v et de préférence au plus égale à 2000v.

8. Vitrage selon l'une des revendications précédentes dans lequel pour les couches déposées en HPPMS les impulsions appliquées à la cathode sont en tension unipolaire et de forme sensiblement rectangulaire.

9. Vitrage selon l'une des revendications 1 à 7 dans lequel pour les couches déposées en HPPMS deux cathodes sont couplées et les impulsions appliquées sont bipolaires et de forme sensiblement rectangulaire.

10. Vitrage selon l'une des revendications précédentes dans lequel une couche diélectrique déposée par HPPMS est l'une du groupe comprenant les oxydes les nitrures les oxynitrures des éléments du groupe comprenant Sn, Zn, Ti, Zr, Al, Si, Bi, Ni, Cr, Nb, et les mélanges de ceux-ci.

11. Vitrage selon la revendication 10 dans lequel une couche diélectrique déposée par HPPMS est formée à partir d'un des éléments du groupe en question avec un second élément en faible proportion formant dopant du premier.

12. Vitrage selon l'une des revendications précédentes dans lequel le système de couches comprend une couche au contact de la couche métallique formée d'un oxyde à base de Zn, déposée par HPPMS.

13. Vitrage selon l'une des revendications 1 à 11 dans lequel, le système de couches comprend au moins une couche à base d'oxyde de titane et une couche à base d'oxyde de zinc, l'une d'entre elle au moins déposée par HPPMS.

14. Vitrage selon l'une des revendications 2 à 13 comprenant une couche d'argent correspondant à une quantité d'argent par unité de surface de 80 à 160mg/m², et de préférence de 100 à 140mg/m².

15. Vitrage bas émissif selon la revendication 14 dans lequel la couche d'argent pour une masse par unité de surface de 120 à 135mg/m² présente une émissivité normale qui n'est pas supérieure à 0,045 et de préférence pas supérieure à 0,040.

16. Vitrage selon la revendication 14 dans lequel la résistance de surface pour une quantité d'argent de 120 à 140mg/m² est au plus égale à 3,8Ω/□

17. Vitrage selon l'une des revendications 2 à 13, comprenant au moins deux couches d'argent séparées par des couches diélectriques **caractérisé en ce qu'**au moins une couche diélectrique sous l'une quelconque des couches d'argent, est obtenue par dépôt HPPMS.

18. Vitrage selon la revendication 14 dans lequel l'efficacité de l'argent est inférieure à - 200LogₙQ+1400, Q étant la quantité d'argent exprimée en mg/m².
